# EUROPEAN PATENT APPLICATION

(11) **EP 4 597 349 A1**
(43) Date of publication of application: **06.08.2025**
(21) Application number: 25154767.5
(22) Date of filing: 29.01.2025
(51) Int. Cl.: G06F 30/18, G06F 30/27, G06Q 10/047

(54) **ARTIFICIAL INTELLIGENCE SUITE FOR OPTIMIZING INDUSTRIAL PLANT DESIGNS**

(30) Priority: 31.01.2024 US 202463627414 P; 20.06.2024 US 202418749042
(71) Applicant: AVEVA Software, LLC, Lake Forest, CA 92630 (US)
(72) Inventor: SUNG, Edwin, Lake Forest, 92630 (US); TOFANO, Samuele, Lake Forest, 92630 (US); WANKHEDE, Moresh, Lake Forest, 92630 (US); CASTANO, Nicola, Lake Forest, 92630 (US)
(74) Representative: WBH Wachenhausen Patentanwälte PartG mbB

(57) **Abstract**

An artificial intelligence search engine integrates engineering knowledge and three-dimensional routing space treatment. A graphical user interface (GUI) prompts a user to input starting and ending points corresponding to conduits of a specified type, via an interactive three-dimensional model of a space in an industrial plant. The artificial intelligence search engine determines an optimal path from multiple three-dimensional path options corresponding to each conduit, based on a design constraint and/or objective. A machine-learning model modifies the optimal path options, based on previous user actions responding to previous optimal path options. The GUI displays the modified path options via the interactive three-dimensional model of the space. A natural language processor executes to: i) query engineering information, ii) operate the artificial intelligence search engine to generate design options, iii) deploy user-selected options, or iv) adapt the modified path options, in response to user actions.

## Description

### CROSS-REFERENCE TO RELATED CASES

This application claims priority to U.S. Provisional Patent Application No. 63/627,414 filed January 31, 2024, which is hereby incorporated herein by reference.

### BACKGROUND

Conventional engineering design processes for engineering, procurement, and construction projects are often plagued by slow and iterative workflows, which are largely manual and contribute significantly to extended project timelines. One key issue is the inefficiency in the design and delivery processes of engineering, procurement, and construction projects is building energy infrastructure. Today's laborious human-driven manual methods often lack the ability to comprehensively explore intricate design spaces, leading to suboptimal solutions, prolonged timelines, and increased costs. Design engineers in engineering, procurement, and construction companies are faced with increasingly complex and competing multi-objective and multi-disciplinary scenarios whilst asked to meet both cost and sustainability targets. Many existing solutions primarily focus on conventional two-dimensional design because current three-dimensional design approaches are slow, expensive, and often environmentally suboptimal. Furthermore, optimal solutions may be missed by conventional rule-based or deterministic systems or algorithms.

### BRIEF DESCRIPTION OF THE DRAWINGS

FIG. 1 illustrates a block diagram of an example system for an artificial intelligence suite that optimizes industrial plant designs, under an embodiment;
FIG. 2 illustrates an example high-level architecture for an artificial intelligence suite that optimizes industrial plant designs, under an embodiment;
FIG. 3 illustrates an example flowchart architecture for an artificial intelligence suite that optimizes industrial plant designs, under an embodiment;
FIG. 4 illustrates an example graphical user interface for an artificial intelligence suite that optimizes industrial plant designs, under an embodiment;
FIG. 5 is a flowchart that illustrates a computer-implemented method for an artificial intelligence suite that optimizes industrial plant designs, under an embodiment; and
FIG. 6 is a block diagram illustrating an example hardware device in which the subject matter may be implemented.

### DETAILED DESCRIPTION

Embodiments of this disclosure provide an artificial intelligence suite that optimizes industrial plant designs. An artificial intelligence search engine integrates engineering knowledge and three-dimensional routing space treatment. A graphical user interface prompts a user to input starting points and ending points, corresponding to conduits of a specified type, via an interactive three-dimensional model of a space in an industrial plant. Multiple three-dimensional path options are generated from a starting point to an ending point corresponding to each of the conduits.

The artificial intelligence search engine determines an optimal path option from the multiple three-dimensional path options corresponding to each of the conduits, based on a design constraint and/or a design objective. A machine-learning model modifies the optimal path options, based on previous user actions responding to previous optimal path options. The graphical user interface displays the modified path options via the interactive three-dimensional model of the space in the industrial plant. A natural language processor executes to: i) query engineering information, ii) operate the artificial intelligence search engine to generate design options, iii) deploy user-selected options, or iv) adapt the modified path options, in response to user actions.

For example, an artificial intelligence search engine integrates engineering knowledge and three-dimensional routing space treatment, which includes engineering knowledge and space treatment for heating, ventilation, and air-conditioning utility plants. A graphical user interface prompts a user to input starting points for chilled water supply pipes and chilled water return pipes and ending points for the chilled water supply and return pipes via an interactive three-dimensional model of a heating, ventilation, and air-conditioning utility plant. A three-dimensional path finder engine generates multiple three-dimensional path options for each of the chilled water supply and return pipes. The artificial intelligence search engine uses design constraints and design objectives to determine the optimal path options for each of the chilled water supply and return pipes. A machine-learning model uses previous user actions responding to previous optimal path options for chilled water supply and return pipes to modify the optimal path options by increasing the three-dimensional distance between some surface areas of the chilled water supply and return pipes and some surface areas of previously routed de-superheated steam supply pipes and de-superheated steam return pipes,

The graphical user interface displays the increased three-dimensional distances between some surface areas of the chilled water supply and return pipes and some surface areas of the de-superheated steam supply and return pipes in the heating, ventilation, and air-conditioning utility plant. A large language model provides a technical explanation to the user that some industrial engineers have increased the minimum three-dimensional distance allowed between surface areas of chilled water supply and return pipes and surface areas of de-superheated steam supply and return pipes even though the industrial engineering layout guidelines specify that with proper insulation the exterior surfaces of the de-superheated steam supply and return pipes should not become hot enough to radiate sufficient heat to raise the temperature of either the chilled water supply pipes or the chilled water return pipes. Satisfied with the large language model's technical explanation, the user instructs the large language model to query engineering information to identify the closest remaining three-dimensional distances between the surface areas of the chilled water supply and return pipes and surface areas of the de-superheated steam supply pipes and return pipes. Then the user instructs the large language model to instruct the artificial intelligence search engine to determine the largest possible increase in three-dimensional distances between the surfaces within the restrictions of the surrounding structures, Then the large language model enables the user to increase the three-dimensional distances between some surface areas of the chilled water supply and return pipes and some surface areas of the de-superheated steam supply and return pipes, and then deploys the twice modified three-dimensional paths for the chilled water supply and return pipes.

Various embodiments and aspects of the disclosures will be described with reference to details discussed below, and the accompanying drawings will illustrate the various embodiments. The following description and drawings are illustrative of the disclosure and are not to be construed as limiting the disclosure. Numerous specific details are described to provide a thorough understanding of various embodiments of the present disclosure. However, in certain instances, well-known or conventional details are not described in order to provide a concise discussion of embodiments of the present disclosure.

Although these embodiments are described in sufficient detail to enable one skilled in the art to practice the disclosed embodiments, it is understood that these examples are not limiting, such that other embodiments may be used, and changes may be made without departing from their spirit and scope. For example, the operations of methods shown and described herein are not necessarily performed in the order indicated and may be performed in parallel. It should also be understood that the methods may include more or fewer operations than are indicated. In some embodiments, operations described herein as separate operations may be combined. Conversely, what may be described herein as a single operation may be implemented in multiple operations.

Reference in the specification to "one embodiment" or "an embodiment" or "some embodiments," means that a particular feature, structure, or characteristic described in conjunction with the embodiment may be included in at least one embodiment of the disclosure. The appearances of the phrase "an embodiment" or "the embodiment" in various places in the specification do not necessarily all refer to the same embodiment.

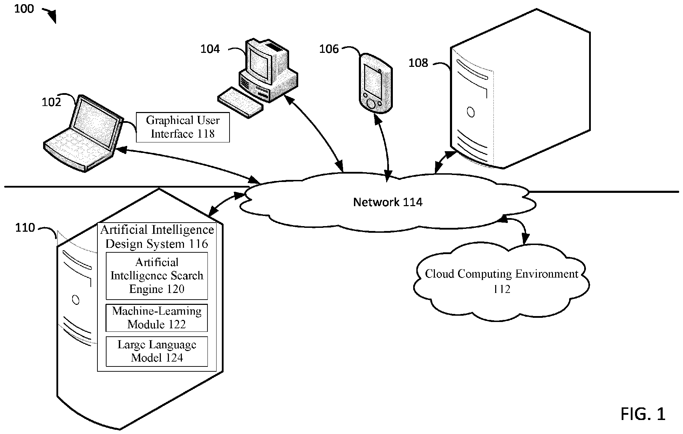

FIG. **1** illustrates a block diagram of an example system **100** for an artificial intelligence suite that optimizes industrial plant designs, under an embodiment. As shown in FIG. **1****,** the system **100** may illustrate a cloud computing environment in which data, applications, services, and other resources are stored and delivered through shared data centers and appear as a single point of access for the users. The system **100** may also represent any other type of distributed computer network environment in which servers control the storage and distribution of resources and services for different client users.

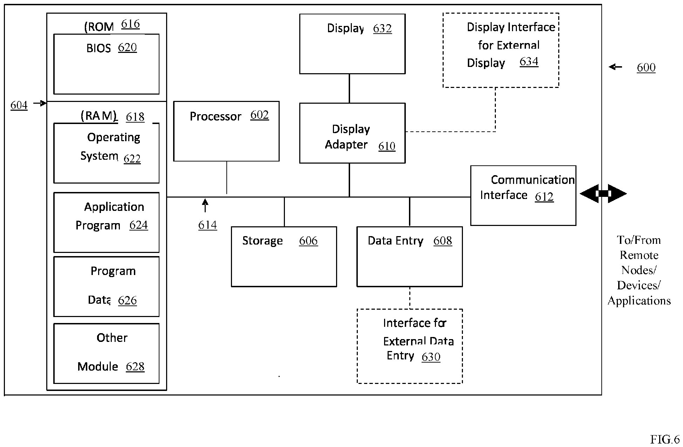

In an embodiment, the system **100** represents a cloud computing system that includes a first client **102,** a second client **104,** a third client **106,** a fourth client **108,** and a server **110** and an optional cloud computing environment **112** that may be provided by a hosting company. The clients **102 - 108,** the server **110,** and the cloud computing environment **112** communicate via a network **114.** Even though FIG. 1 depicts the first client **102** as a laptop computer **102,** the second client **104** as a desktop computer **104,** the third client **106** as a smart phone **106,** and the fourth client **108** as a server, each of the system components **102 -110** may be any type of computer system, and may each be substantially similar to the hardware device **600** depicted in FIG. **6** and described below.

The server **110** can host and execute an artificial intelligence design system **116** that generates industrial engineering layout designs, which may be accessed via a graphical user interface **118,** as depicted by Fig. 1, and/or reside on any of the clients **102 - 108.** Although FIG. 1 depicts all of the artificial intelligence design system **116** residing completely on the server **110,** any or all of the artificial intelligence design system **116** may reside completely on the clients **102 - 108,** completely on the cloud computing environment **112,** or in any combination of partially on the clients **102 -108,** partially the server **110,** partially on the cloud computing environment **112** and/or partially on another server which is not depicted in FIG. **1.** FIG. 1 depicts the system **100** with four clients **102 -108,** one server **110,** one cloud computing environment **112,** one network **114,** one artificial intelligence design system **116,** and one graphical user interface **118,** but the system **100** may include any number of clients **102 - 108,** any number of servers **110,** any number of cloud computing environment **112,** any number of network **114,** any number of artificial intelligence design system **116,** and any number of graphical user interface **118.** The artificial intelligence design system **116** includes an artificial intelligence search engine **120, a** machine-learning module **122,** and a large language model **124,** each of which is described in more detail below.

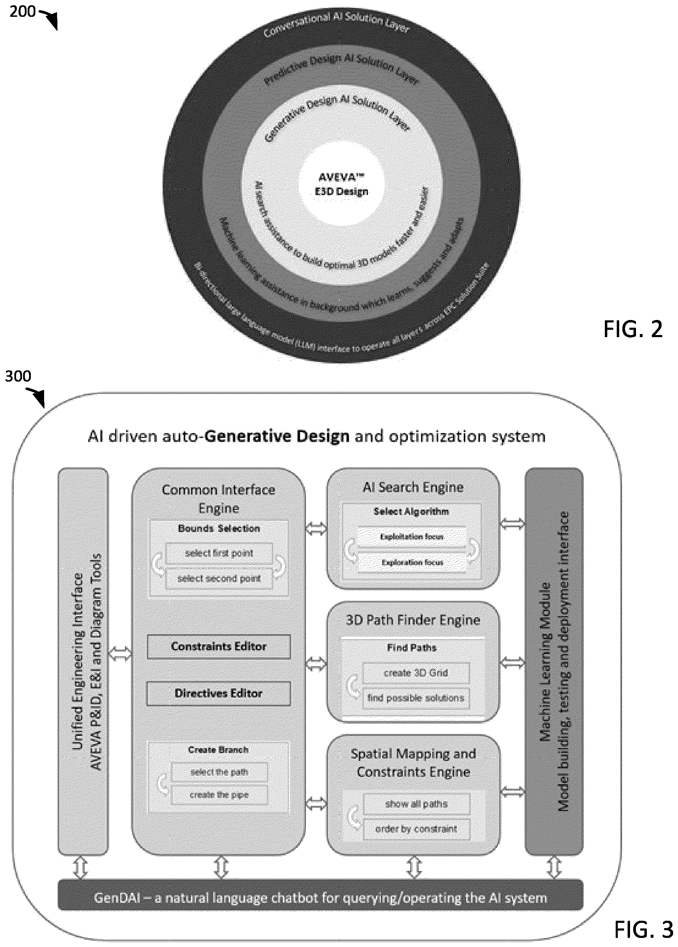

Fig. **2** depicts a circular diagram which describes a high-level architecture **200** for the automated and interactive artificial intelligence design system **116** that generates industrial engineering layout designs. The artificial intelligence design system **116** includes three operational layers in the high-level architecture **200.** The first operational layer is an artificial intelligence search engine **120** that is activated whenever an artificial intelligence search assistant is engaged by a human designer to build optimal three-dimensional design models faster and easier. The second operational layer is a machine-learning module **122** that incorporates many machine-learning models that offer a predictive design solution layer wherein the machine learning models-as-a-service is deployed by human designer in background, which learn, adapt and dynamically suggest design elements. The third operational layer is a natural language processor **126** in the form of a bi-directional large language model as part of a conversational solution layer wherein a human designer searches for one-dimensional, two-dimensional, and/or three-dimensional engineering information and execute discipline specific tasks, such as building three-dimensional models via specifications in a statement format.

Fig. 3 depicts a flowchart architecture **300** that highlights where data is coming from, how data from different sources and processes may be combined and passed to the artificial intelligence search engine **120's** algorithms using input channels and how it may be enriched further for usage in different scenarios using machine learning modules **122** and a large language model **124** that searches and queries technologies. A differentiator in the artificial intelligence design system **116** is how data is ingested, processed by exploration and exploitation focused artificial intelligence algorithms of the artificial intelligence search engine **120,** and then converted into executable three-dimensional design elements options. Unlike conventional design systems, the design engineer has to provide little upfront information via a common interface engine, specify bounds, constraints and objectives (which may be referred to as directives) and pass it on to the artificial intelligence search engine **120,** which is of sub-symbolic paradigm and requires little historical information of the problem statement, yet rapidly produces design routing options which are inherently clash-free out of the box. The artificial intelligence search engine **120** utilizes evolutionary search and optimization algorithms to navigate a vast and complex three-dimensional design space.

The utilization of sub-symbolic artificial intelligence algorithms of evolutionary search and optimization is a distinct feature. Unlike rule-based or deterministic systems, these algorithms empower the artificial intelligence search engine **120** to explore a vast design space iteratively and uncover solution options that may elude conventional engineering methodologies.

The key differentiators and advantages of the artificial intelligence design system **116** over alternative approaches lie in its evolutionary leap. The artificial intelligence design system **116** leverages evolutionary search and optimization algorithms, distinguishing it from deterministic approaches. The sub-symbolic artificial intelligence foundation enables the artificial intelligence search engine **120** to iteratively explore and refine design options, fostering adaptability and uncovering optimal solutions that might have been missed by conventional rule-based systems. Integrated operation of a hybrid design space exploration/exploitation artificial intelligence search strategy for three-dimensional spatial routing problems. The hybrid exploration/exploitation artificial intelligence search strategy binds user-requirements and engineering knowledge to provide a cohesive set of deployable outcomes on demand.

The sub-symbolic artificial intelligence search engine **120** may be enhanced using the machine learning module **122,** which incorporates and utilizes multiple machine-learning models for more accurate and relevant problem setup and also produce more relevant outputs via reliability, constructability and feasibility checks. The machine learning module **122** can continuously self-learn, adapt and better check generative layers output through positive feedback loop. Machine learning integration plays a pivotal role in enhancing the artificial intelligence design system **116's** decision-making capabilities. This data-driven approach not only streamlines the design process, but also ensures that decisions are informed by real-world outcomes, improving the overall efficiency and effectiveness of design projects.

The incorporation of machine learning for decision-making represents a paradigm shift. Rather than relying solely on deterministic algorithms, the artificial intelligence design system **116** can learn from historical project data. This adaptive learning enables the artificial intelligence design system **116** to make informed design choices, improving accuracy and optimizing solutions based on real-world outcomes.

The incorporation of machine learning contributes to data-driven decision-making. The machine learning module **122** learns from historical project data, enabling it to predict optimal design choices, adapt to changing project requirements, and continuously improve its decision-making accuracy. This dynamic learning capability sets it apart from static algorithms, enhancing the artificial intelligence design system **116'**s ability to address evolving challenges in energy infrastructure design projects.

The machine learning module **122** has the ability to integrate a reference dataset to learn from and guide artificial intelligence algorithms search process, and the ability to build usage patterns in a form of feedback from accessed data and user actions taken. Subsequently, it will also automatically provide an ability to build human-choice patterns in the form of a feedback loop or a historical reference dataset to guide later processes by the artificial intelligence search engine **120** in-context for faster and better design decision-making.

As both the generative and predictive layers may be deployed for any discipline of engineering, they may be extended to work in parallel across all these disciplines and communicate seamlessly, thus providing early warning or impact consideration of one discipline engineer to another. The conversational artificial intelligence layer of the bi-directional large language model **124** then integrates and wraps the two underlying layers for an easy to use, prompt-based natural language tool, for rapid engineering search, summarization and execution workflow, all through the same graphic user interface **118** concurrently for entire project team. The use of the large-language model **124** to execute iterative design optimization facilitates seamless communication and collaboration amongst different stakeholders in natural language. Multi-disciplinary engineers and other stakeholders can ask for guidance, search, and summarize information quickly or action three-dimensional design elements built and edited through prompts all in real-time collaborative environment.

The large-language model **124** is a collaborative tool that introduces a novel dimension to stakeholder engagement. Unlike conventional design systems, this feature allows multi-discipline engineers and domain experts to communicate and contribute using natural language. This enhances multidisciplinary collaboration, fostering a more inclusive and efficient three-dimensional design process.

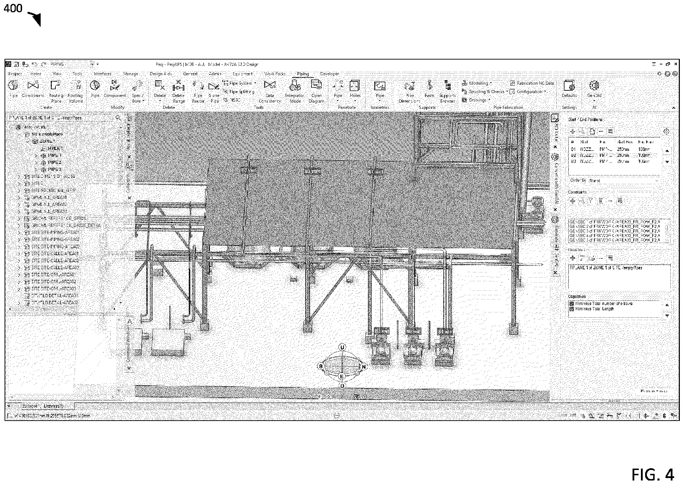

FIG. 4 illustrates an example graphical user interface **400** for an artificial intelligence suite that optimizes industrial plant designs, under an embodiment. Leaving clunky interfaces behind, the large-language model **124** as a collaborative tool introduce a novel and inclusive dimension to stakeholder engagement using natural language. This fosters effective communication and knowledge transfer among multi-disciplinary engineers, and domain experts. Unlike alternatives that may lack a natural language interface, this feature streamlines collaboration, ensuring a multidisciplinary approach to design decision-making.

The artificial intelligence design system **116** is a generative artificial intelligence - driven engineering design system for accelerating energy infrastructure engineering, procurement, and construction projects. Conventional engineering design processes for engineering, procurement, and construction projects are often plagued by slow and iterative workflows, which are largely manual and contribute significantly to extended project timelines. To remove this critical bottleneck, the artificial intelligence design system **116** targets the transformation of the engineering design phase in engineering, procurement, and construction projects by developing and deploying an artificial intelligence search engine **120,** which can provide for a rapid, automatic, interactive creation of three-dimensional design model options (piping, structures, equipment, electrical, heating, ventilation, and air-conditioning, etc.) for a user to choose from and implement. Replacing conventional laborious human-driven design of today's processes with artificial intelligence-driven but human-chosen design process of tomorrow, the artificial intelligence design system **116** addresses the multifaceted challenges within certain energy infrastructure design development.

One key issue is the inefficiency in the conventional design and delivery processes of engineering, procurement, and construction projects building energy infrastructure. Conventional human-driven manual methods often lack the ability to comprehensively explore intricate design spaces, leading to suboptimal solutions, prolonged timelines, and increased costs. The artificial intelligence design system **116** is an artificial intelligence-driven three-dimensional generative design system that aims to revolutionize this paradigm by leveraging sub-symbolic artificial intelligence search algorithms, machine learning, and large-language models. Faster and cheaper energy infrastructure engineering, procurement, and construction projects mean lower energy bills, boosting economic competitiveness and household security. Efficiency is paramount in the transition to sustainable energy sources, and the artificial intelligence design system **116** accelerates decision-making, optimizes designs, and streamlines project delivery.

By prioritizing sustainability and integrating eco-friendly practices, the artificial intelligence design system **116** aligns with the commitment to reducing carbon emissions, meeting renewable energy targets, and advancing environmental responsibility. The importance of this artificial intelligence design system **116** lies in its potential to reshape how energy infrastructure designs are conceptualized and implemented for sustainability. By focusing on sustainability and offering multidimensional generative design the artificial intelligence design system **116** is a leap forward over conventional artificial intelligence-driven design systems. A sustainable practices framework may also be incorporated, which guides the optimisation system to prioritize design choices with reduced carbon footprints.

The integration of three-dimensional generative design represents a significant departure from conventional two-dimensional-centric approaches. By extending generative design into three dimensions, the artificial intelligence design system **116** enhances visualization and facilitates a more nuanced exploration of spatial configurations. Conventional three-dimensional design approaches are slow, expensive, and often environmentally suboptimal.

The cutting-edge artificial intelligence design system **116** rises to this challenge by transforming the way it designs process or power plants with sustainability at its core. The emphasis on three-dimensional generative design is groundbreaking. Many design systems primarily focus on two-dimensional design, whereas the artificial intelligence design system **116** focuses the generative design capabilities into the three-dimensional realm. This not only enhances visualization but also enables the exploration of complex spatial configurations, fostering a more comprehensive understanding of the sustainable design options. As the artificial intelligence design system **116** consists of multiple layers of technologies, embedded generative design along with a large-language model that may be cloud-based, ensuring a modular design would allow for flexible implementation and adaptation to different user configurations, catering to a wider range of customers.

By shifting optioneering much earlier in the design phase, the artificial intelligence design system **116** aims to maximize productivity, efficiency, and environmental consciousness of energy infrastructure projects. At its core, the artificial intelligence design system **116** incorporates a cutting-edge three-dimensional generative design system that converges sub-symbolic artificial intelligence algorithms, machine learning, and large-language models to revolutionize the process of designing energy infrastructure. Overall, the artificial intelligence designer system **116** can expedite engineering, procurement, and construction project delivery by significantly reducing the design iteration times and optimizing resource allocation. The artificial intelligence design system **116** is innovative both in its underlying artificial intelligence and its application, setting it apart from current offerings in the field.

Aspects of the innovation lie in its multi-layered and coordinated suite of artificial intelligence techniques and their revolutionary application to build and deploy three-dimensional designs faster. While existing design systems might utilize some of these elements, none offer the same level of comprehensive integration. In summary, the artificial intelligence design system **116** stands out due to its fusion of multiple artificial intelligence techniques. By embracing innovation in both design philosophy and technological foundations, this artificial intelligence design system **116** offers a holistic, efficient, and superior alternative to conventional design methodologies.

An intelligent generative design search and optimization methodology that automates design process of three-dimensional routed elements for industrial plant design is disclosed. The methodology includes encoding engineering knowledge, three-dimensional routing space treatment, requirements consideration, specifying design objectives and design constraints of a given three-dimensional design search problem and subsequent automatic provision of relevant design variants, ranked in-context and interactable before deployment, to the designer. This innovative artificial intelligence design system **116** delivers multiple benefits (1) provides end-to-end three-dimensional auto-routing of elements on-demand, producing optimal (constructable, always clash free and sustainable) routing options (2) empowers designers through reduction in manual effort required by enabling an intelligent designer-as-a-service, which enables easier collaboration between multi-discipline three-dimensional designers to reduce costs, timescales, and commercial risks. The artificial intelligence design system **116** integrates engineering knowledge and practice rules, and provides the ability to visualize any results that are output before deploying these results.

The artificial intelligence design system **116** also offers the ability to rank results that are outputs based on target objectives before deploying such results, and the ability to adapt design objectives and design constraints on-demand to enhance output results quality. The different aspects of this artificial intelligence design system **116** operate in tandem and provide the unique ability to specify and adapt design problem on-demand, rapidly search design space, iteratively generate routing options, rank and visualize these options before acceptance by using user-supplied relevant information.

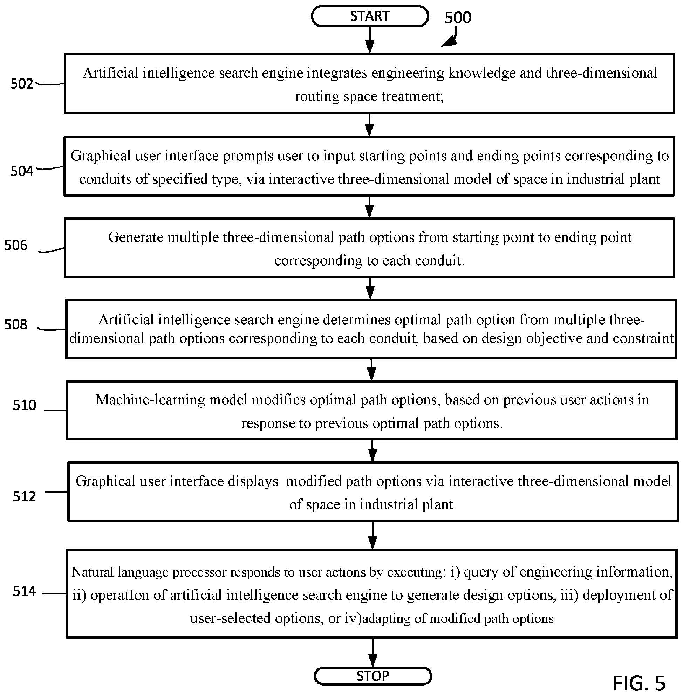

FIG. **5** is a flowchart that illustrates a computer-implemented method for an artificial intelligence suite that optimizes industrial plant designs, under an embodiment. Flowchart **500** depicts method acts illustrated as flowchart blocks for certain actions involved in and/or between the system elements **102 -124** of FIG. 1.

An artificial intelligence search engine integrates engineering knowledge and three-dimensional routing space treatment, block **502.** The system prepares an artificial intelligence search engine to assist in generating designs for industrial plants. For example, and without limitation, this can include the artificial intelligence search engine **120** integrating engineering knowledge and three-dimensional routing space treatment, which includes engineering knowledge and spatial treatments for heating, ventilation, and air-conditioning utility plants.

An artificial intelligence search engine can be a computer software system that can retrieve information about industrial plant layouts. Engineering knowledge can be facts and information about the branch of science and technology concerned with the design, building, and use of engines, machines, and structures. Three-dimensional routing space treatment can be how a path is presented though an area which appears to have the dimensions of height, length, and width.

Engineering knowledge and three-dimensional routing space treatment can include practice rules, requirements consideration, design objectives, design constraints, cost targets, and/or sustainability targets. For example, a practice rule may be a series of if-then-else questions that a user has to apply to each individual conduit that is to be routed through a three-dimensional model of space in an industrial plant.

A practice rule can be the actual application or use of an idea or method regarding principles governing conduct within a particular activity or sphere. A requirements consideration can be carefully thought about a thing that is needed or wanted. A design objective can be a plan to achieve production to show the look and function of an object before it is built or made.

A design constraint can be a limitation or restriction regarding a plan produced to show the look and function of an object before it is built or made. A cost target can be the estimated price for an objective or result toward which efforts are directed. A sustainability target can be the ability to be maintained at a rate for an objective or result toward which efforts are directed.

After an artificial intelligence search engine integrates three-dimensional routing space treatment, a graphical user interface prompts a user to input starting points and ending points corresponding to conduits of a specified type, via an interactive three-dimensional model of a space in an industrial plant, block **504.** The system prompts a user to provide information that initiates the automated design of an industrial plant layout. By way of example and without limitation, this can include the graphical user interface **118** prompting a user to input starting points for chilled water supply pipes and chilled water return pipes, and also to input ending points for the chilled water supply pipes and the chilled water return pipes via the interactive three-dimensional model, as depicted within the graphic user interface by Fig. 4, of a heating, ventilation, and air-conditioning utility plant.

A graphical user interface can be the computer display by which a human and a computer system interact, in particular the input devices and software that interact with the human. A user can be a person who is interacting with a computer. A starting point can be a beginning at a particular spot, place, or position in an area. An ending point can be the final part at a particular spot, place, or position in an area. A conduit can be a channel that conveys something.

A specified type can be a clearly identified category of things having common characteristics. An interactive three-dimensional model can be a computer representation of a proposed structure which appears to have length, breadth, and depth, and which allows a two-way flow of information between the computer and the computer-user. A space can be an area with the dimensions of height, length, and width. An industrial plant can be a factory or similar place where manufacturing and/or distribution takes place.

A conduit may be an appropriate type of channel for conveying water, a liquid, a gas, electricity, heat, and/or air conditioning. For example, a conduit may be an electrical cable that provides electricity to an air-conditioning unit, or a ventilation duct that provides air-conditioning to people in an office building. A type can be a category or classification. Water can be a colourless, transparent, and odourless liquid. A liquid can be a substance that flows freely but is of constant volume.

A gas can be a substance in a state in which it will expand freely to fill the whole of a container, having no fixed shape (unlike a solid) and no fixed volume (unlike a liquid). Electricity can be a form of energy resulting from the existence of charged particles. Heat can be the quality of being hot, or a high temperature. Air conditioning can be a system for controlling the humidity, ventilation, and temperature in a building, typically to maintain a cool atmosphere in warm conditions.

Following the input of starting points and ending points corresponding to conduits of a specified type, via an interactive three-dimensional model, multiple three-dimensional path options are generated from a starting point to an ending point corresponding to each of the conduits, block **506.** The system iteratively generates path options for conduits of a specific type. In embodiments, this can include a three-dimensional path finder engine generating multiple three-dimensional path options for each of the chilled water supply and return pipes. A three-dimensional path option can be a route which is chosen or may be chosen, and which appears to have length, breadth, and depth.

Generating the path options for each conduit may include organizing the path options into compatible sets of path options, with each set ranked by at least one of the at least one design constraint and/or the at least one design objective. For example, when four chilled water supply and return pipes are routed from a heating, ventilation and air-conditioning utility plant, the artificial intelligence search engine **120** applies the highest weight to a design constraint and applies the second highest weight to a design objective to produce a set of four optimal path options that are ranked first based on a design constraint and ranked second based on a design objective. The artificial intelligence search engine **120** may also apply the second highest weight to the design constraint and apply the highest weight to the design objective to produce a slightly different set of six optimal path options that are ranked first based on the design objective and ranked second based on the design constraint. In another example, the artificial intelligence search engine **120** may use only one design constraint to produce a set of four optimal path options that are ranked first based on the design constraint. In yet another example, the artificial intelligence search engine **120** may use only one design objective to produce a set of four optimal path options that are ranked first based on the design objective. A compatible set can be a group or collection of things that belong together, resemble one another, or are usually found together, and are able to exist or occur together without conflict.

Having generated multiple three-dimensional path options from a starting point to an ending point corresponding to each of the conduits, the artificial intelligence search engine determines an optimal path option from the multiple three-dimensional path options corresponding to each of the conduits, based on a design constraint and/or a design objective, block **508.** The system uses design objectives and constraints for the conduits to identify optimal path options. For example, and without limitation, this can include the artificial intelligence search engine **120** using design constraints and design objective to determine the optimal path options for each of the chilled water supply and return pipes. An optimal path option can be a route which is the best, or most favourable, and which is chosen or may be chosen.

A design constraint and/or a design objective for the conduits may be input via at least one of the graphical user interfaces or the natural language processor, and the optimal path options are constructable, sustainable based on layout options, and inherently clash free based on sequencing the processing of the conduits. For example, the large language model **124** responds to the user selecting the starting points and the ending points for the chilled water supply and return pipes, then asks the user if the user wants to continue with the same design constraint and design objective that a previous user selected for the chilled water supply and return pipes or update the design constraint and /or the design objective for the chilled water supply and return pipes. In another example, the optimal path options are inherently clash free because the three-dimensional path finder engine identifies the path for each conduit sequentially, such that after the three-dimensional path finder engine identifies the first path option for the first conduit, then the three-dimensional path finder engine will not consider any part of the first path option for the first conduit as a potential location for any parts of the path options for the second, third, or fourth conduits.

After the three-dimensional path finder engine identifies the first path option for the second conduit, then the three-dimensional path finder engine will not consider any parts of the path options for the first or second conduit as a potential location for any parts of the path options for the third or fourth conduits. The three-dimensional path finder engine continues this process until path options have been identified for all of the conduits. If more path options are required for the conduits, then the three-dimensional path finder engine repeats this process from the beginning until a sufficient number of path options have been identified for all the conduits.

Constructable can be capable of being built, assembled, or composed, Sustainable can be able to be maintained at a certain rate or level. A layout option can be the way in which the parts of something are arranged, and which is chosen or may be chosen. Clash free can be without or absent a confrontation.

After an artificial intelligence search engine uses a design constraint and/or a design objective to determines an optimal path option from the multiple three-dimensional path options corresponding to each of the conduits, a machine-learning model modifies the optimal path options, based on previous user actions responding to previous optimal path options, block **510.** The system learned how to improve some optimal path options. By way of example and without limitation, this can include the machine-learning model **122** using previous user actions responding to previous optimal path options for chilled water supply and return pipes by modifying the optimal path options through increasing the three-dimensional distance between some surface areas on the chilled water supply and return pipes and some surface areas on the de-superheated steam supply and return pipes.

The artificial intelligence design system **116** adhered to the published industrial engineering guidelines regarding the required three-dimensional distance between any surface areas on the chilled water supply and return pipes and any surface areas on the de-superheated steam supply and return pipes, to prevent the hot de-superheated steam supply and return pipes from inadvertently raising the temperature of the much cooler chilled water supply and return pipes. However, some of the industrial engineers who used the artificial intelligence design system **116** have modified their displayed optimal path options to increase the three-dimensional distance between some of the surface areas on the chilled water supply and return pipes and some of the surface areas on the de-superheated steam supply and return pipes. The machine-learning model **122** infers that these industrial engineers increased the three-dimensional distance between some surface areas on the chilled water supply and return pipes and some surface areas on the de-superheated steam supply and return pipes as a precautionary measure for when the insulation on the pipes may not be sufficient to prevent temperature increases by the de-superheated steam supply and return pipes on the chilled water supply and return pipes. Such a learning increased the probability that the machine-learning model **122** will make similar modifications to the optimal path options in the future. A previous user action can be a physical activity by a person when they interacted with a computer in the past. A previous optimal path option can be a route which was the best, or was the most favourable, and which was chosen or may have been chosen..

Following a machine-learning model modifying the optimal path options, based on previous user actions responding to previous optimal path options, the graphical user interface displays the modified path options via the interactive three-dimensional model of the space in the industrial plant block **512.** The system displays any modifications made by the machine-learning model. In embodiments, this can include the graphical user interface **118** displaying the increased three-dimensional distances between surface areas on the chilled water supply and return pipes and some surface areas on the de-superheated steam supply and return pipes.

Having displayed the modified path options via the interactive three-dimensional model of the space in the industrial plant, a natural language processor executes to: i) query engineering information, ii) operate the artificial intelligence search engine to generate design options, iii) deploy user-selected options, or iv) adapt the modified path options, in response to user actions, block **514.** The system enables users to select from several final actions, which include querying engineering information, using artificial intelligence, and/or using other options to adapting the path options before deploying the path options in an industrial plant. For example, and without limitation, this can include the large language model **124** enabling a user to request engineering information to determine the location of the surrounding structures which may be restricting the increase in the three-dimensional distances between the surfaces of the chilled water and the de-superheated steam pipes, and instruct the artificial intelligence search engine to determine the largest possible increase in three-dimensional distances between the surfaces within the restrictions of the surrounding structures, Then the large language model **124** enables the user to further increase, beyond any increases that the machine-learning model had already initiated, three-dimensional distances between some surface areas on the chilled water supply and return pipes and some surface areas on the de-superheated steam supply and return pipes, and then deploy the adapted and modified three-dimensional path options. An adaptation can be a modification or adjustment. A user action can be an activity by a person who is interacting with a computer. Adapting can be modifying or adjusting. Deploying can be bringing into effective action, or utilizing.

The machine learning model **122** may learn from a reference dataset as part of the training of the machine learning model **122,** to guide the artificial intelligence search process, learn from the natural language processor adapting the modified path options, and/or produce additional relevant paths via reliability, constructability and/or feasibility checks. For example, the machine-learning model **122** records that the user listened to the large language model **124** explaining the reason for the increase in three-dimensional distance between some surface areas on the chilled water supply and return pipes and some surface areas on the de=superheated steam supply and return pipes. Next the user instructed the large language model **124** to identify the remaining surface areas which have the closest three-dimensional distances between any surface areas on the chilled water supply and return pipes and any surface areas on the de=superheated steam supply and return pipes. Then the user adapted the modified path options to further increase the three-dimensional distances between some points on the chilled water supply and return pipes and some points on the de-superheated steam supply and return pipes. Such a learning increase the probability that the machine-learning model **122** will make similar modifications to the optimal path options in the future. A reference dataset can be a structured group of information held in a computer, and used to ascertain something. A modified path option can be a revised route which is chosen or may be chosen. A relevant path can be a route that is appropriate for being considered. A reliability check can be an examination to test or ascertain the quality of being trustworthy. A constructability check can be an examination to test or ascertain the ease, efficiency, and eco-friendliness with which a structure is being built. A feasibility check can be an examination to test or ascertain the state or degree of being easily or conveniently done.

Adapting via the natural language processor may include adapting a design objective and/or a design constraint. The natural language processor may be a bi-directional large language model that searches three-dimensional models associated with engineering information, and executes discipline-specific tasks. For example, the large language model **124** has the expanded vocabulary to converse on highly specialized technical topics with engineers in all disciplines. Therefore, the large language model **124** immediately understands and explains the role of the de-superheated steam in increasing the three-dimensional distances on some surface areas of the chilled water supply and return pipes relative to some surface areas on the de-superheated steam supply and return pipes.

However, the electrical engineer who is responsible for routing the electrical cable to the solenoid motors that will operate the values for the de-superheated steam supply and return pipes may not immediately recognize the reference to de-superheated steam. A bi-directional large language model can be an artificial neural network that achieves general purpose communications with humans. A discipline-specific task can be an amount of work associated with a field of engineering.

Although FIG. **5** depicts the blocks **502** - **514** occurring in a specific order, the blocks **502** - **514** can occur in another order. In other implementations, each of the blocks **502** - **514** can also be executed in combination with other blocks and/or some blocks may be divided into a different set of blocks.

An exemplary hardware device in which the subject matter may be implemented shall be described. Those of ordinary skill in the art will appreciate that the elements illustrated in FIG. **6** can vary depending on the system implementation. With reference to FIG. **6****,** an exemplary system for implementing the subject matter disclosed herein includes a hardware device **600,** including a processing unit **602,** a memory **604,** a storage **606,** a data entry module **608,** a display adapter **610,** a communication interface **612,** and a bus **614** that couples elements **604** - **612** to the processing unit **602.**

The bus **614** can comprise any type of bus architecture. Examples include a memory bus, a peripheral bus, a local bus, etc. The processing unit **602** is an instruction execution machine, apparatus, or device and can comprise a microprocessor, a digital signal processor, a graphics processing unit, an application specific integrated circuit (ASIC), a field programmable gate array (FPGA), etc. The processing unit **602** may be configured to execute program instructions stored in the memory **604** and/or the storage **606** and/or received via the data entry module **608.**

The memory **604** can include a read only memory (ROM) **616** and a random-access memory (RAM) **618.** The memory **604** may be configured to store program instructions and data during operation of the hardware device **600.** In various embodiments, the memory **604** can include any of a variety of memory technologies such as static random-access memory (SRAM) or dynamic RAM (DRAM), including variants such as dual data rate synchronous DRAM (DDR SDRAM), error correcting code synchronous DRAM (ECC SDRAM), or RAMBUS DRAM (RDRAM), for example.

The memory **604** can also include nonvolatile memory technologies such as nonvolatile flash RAM (NVRAM) or ROM. In some embodiments, it is contemplated that the memory **604** can include a combination of technologies such as the foregoing, as well as other technologies not specifically mentioned. When the subject matter is implemented in a computer system, a basic input/output system (BIOS) **620,** containing the basic routines that help to transfer information between elements within the computer system, such as during start-up, is stored in the ROM **616.**

The storage **606** can include a flash memory data storage device for reading from and writing to flash memory, a hard disk drive for reading from and writing to a hard disk, a magnetic disk drive for reading from or writing to a removable magnetic disk, and/or an optical disk drive for reading from or writing to a removable optical disk such as a CD ROM, DVD or other optical media. The drives and their associated computer-readable media provide nonvolatile storage of computer readable instructions, data structures, program modules and other data for the hardware device **600.**

It is noted that the methods described herein may be embodied in executable instructions stored in a computer readable medium for use by or in connection with an instruction execution machine, apparatus, or device, such as a computer-based or processor-containing machine, apparatus, or device. It will be appreciated by those skilled in the art that for some embodiments, other types of computer readable media may be used which can store data that is accessible by a computer, such as magnetic cassettes, flash memory cards, digital video disks, Bernoulli cartridges, RAM, ROM, and the like can also be used in the exemplary operating environment. As used here, a "computer-readable medium" can include one or more of any suitable media for storing the executable instructions of a computer program in one or more of an electronic, magnetic, optical, and electromagnetic format, such that the instruction execution machine, system, apparatus, or device can read (or fetch) the instructions from the computer readable medium and execute the instructions for carrying out the described methods. A non-exhaustive list of conventional exemplary computer readable medium includes: a portable computer diskette; a RAM; a ROM; an erasable programmable read only memory (EPROM or flash memory); optical storage devices, including a portable compact disc (CD), a portable digital video disc (DVD), a high-definition DVD (HD-DVD^{™}), a BLU-RAY disc; and the like.

A number of program modules may be stored on the storage **606,** the ROM **616** or the RAM **618,** including an operating system **622,** one or more applications programs **626,** program data **626,** and other program modules **628.** A user can enter commands and information into the hardware device **600** through data entry module **608.** The data entry module **608** can include mechanisms such as a keyboard, a touch screen, a pointing device, etc.

Other external input devices (not shown) are connected to the hardware device **600** via an external data entry interface **610.** By way of example and not limitation, external input devices can include a microphone, joystick, game pad, satellite dish, scanner, or the like. In some embodiments, external input devices can include video or audio input devices such as a video camera, a still camera, etc. The data entry module **608** may be configured to receive input from one or more users of the hardware device **600** and to deliver such input to the processing unit **602** and/or the memory **604** via the bus **614.**

A display **612** is also connected to the bus **614** via the display adapter **610.** The display **612** may be configured to display output of the hardware device **600** to one or more users. In some embodiments, a given device such as a touch screen, for example, can function as both the data entry module **608** and the display **612.** External display devices can also be connected to the bus **614** via the external display interface **634.** Other peripheral output devices, not shown, such as speakers and printers, may be connected to the hardware device **600.**

The hardware device **600** can operate in a networked environment using logical connections to one or more remote nodes (not shown) via the communication interface **612.** The remote node may be another computer, a server, a router, a peer device or other common network node, and typically includes many or all of the elements described above relative to the hardware device **600.** The communication interface **612** can interface with a wireless network and/or a wired network. Examples of wireless networks include, for example, a BLUETOOTH network, a wireless personal area network, a wireless 802. 21 local area network (LAN), and/or wireless telephony network (e.g., a cellular, PCS, or GSM network).

Examples of wired networks include, for example, a LAN, a fiber optic network, a wired personal area network, a telephony network, and/or a wide area network (WAN). Such networking environments are commonplace in intranets, the Internet, offices, enterprise-wide computer networks and the like. In some embodiments, the communication interface **612** can include logic configured to support direct memory access (DMA) transfers between the memory **604** and other devices.

In a networked environment, program modules depicted relative to the hardware device **600,** or portions thereof, may be stored in a remote storage device, such as, for example, on a server. It will be appreciated that other hardware and/or software to establish a communications link between the hardware device **600** and other devices may be used.

It should be understood that the arrangement of the hardware device **600** illustrated in FIG. **6** is but one potential implementation and that other arrangements are feasible. It should also be understood that the various system components (and means) defined by the claims, described below, and illustrated in the various block diagrams represent logical components that are configured to perform the functionality described herein. For example, one or more of these system components (and means) may be realized, in whole or in part, by at least some of the components illustrated in the arrangement of the hardware device **600.**

In addition, while at least one of these components are implemented at least partially as an electronic hardware component, and therefore constitutes a machine, the other components may be implemented in software, hardware, or a combination of software and hardware. More particularly, at least one component defined by the claims is implemented at least partially as an electronic hardware component, such as an instruction execution machine (e.g., a processor-based or processor-containing machine) and/or as specialized circuits or circuitry (e.g., discrete logic gates interconnected to perform a specialized function), such as those illustrated in FIG. **6****.**

Other components may be implemented in software, hardware, or a combination of software and hardware. Moreover, some or all of these other components may be combined, some may be omitted altogether, and additional components may be added while still achieving the functionality described herein. Thus, the subject matter described herein may be embodied in many different variations, and all such variations are contemplated to be within the scope of what is claimed.

In the descriptions above, the subject matter is described with reference to acts and symbolic representations of operations that are performed by one or more devices, unless indicated otherwise. As such, it is understood that such acts and operations, which are at times referred to as being computer-executed, include the manipulation by the processing unit of data in a structured form. This manipulation transforms the data or maintains it at locations in the memory system of the computer, which reconfigures or otherwise alters the operation of the device in a manner well understood by those skilled in the art. The data structures where data is maintained are physical locations of the memory that have particular properties defined by the format of the data. However, while the subject matter is described in a context, it is not meant to be limiting as those of skill in the art will appreciate that various of the acts and operations described hereinafter can also be implemented in hardware.

To facilitate an understanding of the subject matter described above, many aspects are described in terms of sequences of actions. At least one of these aspects defined by the claims is performed by an electronic hardware component. For example, it will be recognized that the various actions may be performed by specialized circuits or circuitry, by program instructions being executed by one or more processors, or by a combination of both. The description herein of any sequence of actions is not intended to imply that the specific order described for performing that sequence must be followed. All methods described herein may be performed in any suitable order unless otherwise indicated herein or otherwise clearly contradicted by context.

While one or more implementations have been described by way of example and in terms of the specific embodiments, it is to be understood that one or more implementations are not limited to the disclosed embodiments. To the contrary, it is intended to cover various modifications and similar arrangements as would be apparent to those skilled in the art. Therefore, the scope of the appended claims should be accorded the broadest interpretation so as to encompass all such modifications and similar arrangements.

## Claims

1. A system for an artificial intelligence suite that optimizes industrial plant designs, the system comprising:
one or more processors; and
a non-transitory computer readable medium storing a plurality of instructions, which when executed, cause the one or more processors to:
integrate, by an artificial intelligence search engine, engineering knowledge and three-dimensional routing space treatment;
prompt, by a graphical user interface, a user to input starting points and ending points corresponding to conduits of a specified type, via an interactive three-dimensional model of a space in an industrial plant;
generate multiple three-dimensional path options from a starting point to an ending point corresponding to each of the conduits;
determine, by the artificial intelligence search engine, an optimal path option from the multiple three-dimensional path options corresponding to each of the conduits, based on at least one of at least one design constraint or at least one design objective;
modify, by a machine-learning model, the optimal path options, based on previous user actions in response to previous optimal path options;
display, via the graphical user interface, the modified path options via the interactive three-dimensional model of the space in the industrial plant; and
execute, in response to user actions, a natural language processor to: i) query engineering information, ii) operate the artificial intelligence search engine to generate design options, iii) deploy user-selected options, or iv) adapt the modified path options.

2. The system of claim 1, wherein engineering knowledge and three-dimensional routing space treatment comprise at least one of practice rules, requirements consideration, design objectives, design constraints, cost targets, or sustainability targets.

3. The system of claim 1, wherein the conduit comprises an appropriate type of channel for conveying at least one of water, a liquid, a gas, electricity, heat, or air conditioning.

4. The system of claim 1, wherein generating the path options for each conduit comprises organizing the path options into compatible sets of path options, with each set ranked by at least one of the at least one design constraint or the at least one design objective.

5. The system of claim 1, wherein at least one of the at least one design constraint or the at least one design objective for the conduits are input via at least one of the graphical user interface or the natural language processor, and the optimal path options are at least one of constructable, sustainable based on layout options, or inherently clash free based on sequencing the processing of the conduits.

6. The system of claim 1, wherein the machine learning model at least one of learns from a reference dataset to guide the artificial intelligence search process, learns from the natural language processor adapting the modified path options, or produces additional relevant paths via at least one of a reliability check, a constructability check, or a feasibility check.

7. The system of claim 1, wherein adapting via the natural language processor comprises adapting at least one of the at least one design constraint or the at least one design objective, and the natural language processor comprises a bi-directional large language model that searches three-dimensional models associated with engineering information, and executes discipline-specific tasks.

8. A computer-implemented method for visualizing data provided by external sources, the computer-implemented method comprising:
integrating, by an artificial intelligence search engine, engineering knowledge and three-dimensional routing space treatment;
prompting, by a graphical user interface, a user to input starting points and ending points corresponding to conduits of a specified type, via an interactive three-dimensional model of a space in an industrial plant;
generating multiple three-dimensional path options from a starting point to an ending point corresponding to each of the conduits;
determining, by the artificial intelligence search engine, an optimal path option from the multiple three-dimensional path options corresponding to each of the conduits, based on at least one of at least one design constraint or at least one design objective;
modifying, by a machine-learning model, the optimal path options, based on previous user actions in response to previous optimal path options;
displaying, via the graphical user interface, the modified path options via the interactive three-dimensional model of the space in the industrial plant; and
executing, in response to user actions, a natural language processor to: i) query engineering information, ii) operate the artificial intelligence search engine to generate design options, iii) deploy user-selected options, or iv) adapt the modified path options.

9. The computer-implemented method of claim 8, wherein engineering knowledge and three-dimensional routing space treatment comprise at least one of practice rules, requirements consideration, design objectives, design constraints, cost targets, or sustainability targets.

10. The computer-implemented method of claim 8, wherein the conduit comprises an appropriate type of channel for conveying at least one of water, a liquid, a gas, electricity, heat, or air conditioning.

11. The computer-implemented method of claim 8, wherein generating the path options for each conduit comprises organizing the path options into compatible sets of path options, with each set ranked by at least one of the at least one design constraint or the at least one design objective.

12. The computer-implemented method of claim 8, wherein at least one of the at least one design constraint or the at least one design objective are input via at least one of the graphical user interface or the natural language processor, and the optimal path options are at least one of constructable, sustainable based on layout options, or inherently clash free based on sequencing the processing of the conduits.

13. The computer-implemented method of claim 8, wherein the machine learning model at least one of learns from a reference dataset to guide the artificial intelligence search process, learns from the natural language processor adapting the modified path options, or produces additional relevant paths via at least one of a reliability check, a constructability check, or a feasibility check.

14. The computer-implemented method of claim 8, wherein adapting via the natural language processor comprises adapting at least one of the at least one design constraint or the at least one design objective, and the natural language processor comprises a bi-directional large language model that at least one of searches three-dimensional models associated with engineering information, or executes discipline-specific tasks.

15. A computer program product, comprising a non-transitory computer-readable medium having a computer-readable program code embodied therein to be executed by one or more processors, the program code including instructions to:
integrate, by an artificial intelligence search engine, engineering knowledge and three-dimensional routing space treatment;
prompt, by a graphical user interface, a user to input starting points and ending points corresponding to conduits of a specified type, via an interactive three-dimensional model of a space in an industrial plant;
generate multiple three-dimensional path options from a starting point to an ending point corresponding to each of the conduits;
determine, by the artificial intelligence search engine, an optimal path option from the multiple three-dimensional path options corresponding to each of the conduits, based on at least one of at least one design constraint or at least one design objective;
modify, by a machine-learning model, the optimal path options, based on previous user actions in response to previous optimal path options;
display, via the graphical user interface, the modified path options via the interactive three-dimensional model of the space in the industrial plant; and
execute, in response to user actions, a natural language processor to: i) query engineering information, ii) operate the artificial intelligence search engine to generate design options, iii) deploy user-selected options, or iv) adapt the modified path options.

16. The computer program product of claim 15, wherein engineering knowledge and three-dimensional routing space treatment comprise at least one of practice rules, requirements consideration, design objectives, design constraints, cost targets, or sustainability targets.

17. The computer program product of claim 15, wherein the conduit comprises an appropriate type of channel for conveying at least one of water, a liquid, a gas, electricity, heat, or air conditioning.

18. The computer program product of claim 15, wherein generating the path options for each conduit comprises organizing the path options into compatible sets of path options, with each set ranked by at least one of the at least one design constraint or the at least one design objective, and wherein at least one of the at least one design constraint or the at least one design objective for the conduits are input via at least one of the graphical user interface or the natural language processor, and the optimal path options are at least one of constructable, sustainable based on layout options, or inherently clash free based on sequencing the processing of the conduits.

19. The computer program product of claim 15, wherein the machine learning model at least one of learns from a reference dataset to guide the artificial intelligence search process, learns from the natural language processor adapting the modified path options, or produces additional relevant paths via at least one of a reliability check, a constructability check, or a feasibility check.

20. The computer program product of claim 15, wherein adapting via the natural language processor comprises adapting at least one of the at least one design constraint or the at least one design objective, and the natural language processor comprises a bi-directional large language model that at least one of searches three-dimensional models associated with engineering information, or executes discipline-specific tasks.
